Europäisches Patentamt

European Patent Office

Office européen des brevets

(19)

(11) Publication number: **0 198 392**
**A1**

# EUROPEAN PATENT APPLICATION

(12)

(21) Application number: **86104781.9**

(22) Date of filing: **08.04.86**

(51) Int. Cl.4: **G03C 1/68**

---

(30) Priority: **10.04.85 US 721644**

(43) Date of publication of application:
**22.10.86 Bulletin 86/43**

(84) Designated Contracting States:
**DE GB**

(71) Applicant: **E.I. DU PONT DE NEMOURS AND COMPANY**
**1007 Market Street**
**Wilmington Delaware 19898(US)**

(72) Inventor: **Briney, Gary Clark**
**400 Mohawk Street**
**Sayre Pennsylvania 18840(US)**
Inventor: **Foreman, Thomas Kevin**
**518 West Lockhart Street**
**Sayre Pennsylvania 18840(US)**

(74) Representative: **Werner, Hans-Karsten, Dr. et al**
**Deichmannhaus am Hauptbahnhof**
**D-5000 Köln 1(DE)**

---

(54) **Partial neutralization of aqueous developable photoresist.**

(57) An aqueous processible photoresist composition comprises a photopolymerizable ethylenically unsaturated monomer, a photoinitiator or photoinitiator system, a partially neutralized carboxylic acid binder.

EP 0 198 392 A1

# PARTIAL NEUTRALIZATION OF AQUEOUS DEVELOPABLE PHOTORESIST

## BACKGROUND OF THE INVENTION

This invention relates to photopolymerizable compositions which can be laminated to a support. More particularly, it relates to aqueous processible resist compositions in which acid groups of the binder are partially neutralized.

Photopolymerizable resist materials are known from U.S. Patent No. 3,469,982 which describes preparing a film resist in the form of a photopolymerizable layer sandwiched between a cover sheet and a temporary support. This film resist may then be laminated to copper or copper-laminated board and exposed and processed to provide a photopolymerized layer which acts as a resist for subsequent etching.

Aqueous processible photopolymerizable resists offer significant advantages to the printed circuit industry in terms of lower costs and environmental safeguards. Acid binders have played an important roll in the production of such resists. Acid binders are described in German Patent 2,123,702; U.S. Patent No. 4,273,857; U.S. Patent No. 3,458,311; and U.K. Patent No. 1,507,704.

In the manufacture of printed circuit boards from photoresist element, it is necessary to laminate the photosensitive layer of the element to the substrate board. U. S. Patent No. 3,547,730 discloses the lamination process whereby the layer achieves sufficient adhesion to the substrate to withstand subsequent photoresist processing steps of development, etching and plating.

U.S. Patent No. 2,893,868 discloses initiation of polymerization including acidic or basic monomer components within a solvent developable photopolymer composition. U.S. Patent No. 4,275,142 discloses a flexographic printing composition in which a copolymer ingredient may be reacted with 0.05 to 1.0 equivalent of base. These publications teach away from the selectivity required herein by suggesting that basic and acidic components can be combined in equal proportions.

It is an object of the method of this invention to provide an element with a greater degree of flexibility in the photosensitive layer prior to lamination to a surface as well as an increased rate of development and stripping for the layer.

## SUMMARY OF THE INVENTION

The present invention is directed to an improved photosensitive element adapted for use as a resist and a method of use particularly in making a printed circuit board. The element which is stored wound in a roll comprises a support film and an aqueous processible polymerizable resist composition comprising a photopolymerizable ethylenically unsaturated monomer, a photoinitiator or photoinitiator system and a partially neutralized acid binder formed from a binder containing carboxylic acid groups with an acid number in the range from 40 to 140 and a base sufficient to neutralize 15 to 55% of the carboxylic acid groups if completely reacted.

## DETAILED DESCRIPTION OF THE INVENTION

The present invention is based on the discovery that improved physical and processing characteristics are produced within an aqueous developable photoresist film via partial neutralization of carboxylic acid groups of a binder with base. This partial neutralization is with a photopolymerizable resist composition which contains a polymerizable ethylenically unsaturated monomer, a photoinitiator or photoinitiation system and an acid binder with an acid number in a range from 40 to 140. Both organic and inorganic bases are suitable with preferred bases including an alkali hydroxide, aliphatic amine, amino substituted acrylic ester, amino substituted methacrylic ester or combination thereof.· The base is added to the photopolymerizable resist composition in amount sufficient to neutralize 15 to 55% opf the available carboxylic acid groups of the acid binder if completely reacted. When the resist composition is coated on a support to produce a film, the partial neutralization increases the flexibility of the film in terms of how it can be handled, stretched or bent without adverse effect. When the film is laminated to a support, the partial neutralization has been found to speed up processing and stripping.

What is meant by the term partial neutralization is that; first the amount of base added is less than would be required to react with all of the acid binder, and second the acid-base reation need not be complete. The amount of base added is present in an amount if completely reacted would neturalize 15 to 55% of the carboxylic acid groups. Infrared stretching frequency tests on controls and partially neutralized films prepared according to the invention indicate that triethyl amine, triethanol amine and potassium hydroxide are all equally effective in reacting with the acid binder.

The upper range of operation for partial neutralization, i.e., 55%, is controlled by adverse effects in terms of the inability of the composition to adhere to a support and the inability to produce a strippable resist particularly with considerable higher neutralization. The problem with adhesion is believed to be due to the increase in ionic content produced by neutralization. The problem with producing a strippable resist appears to be due to spontaneous dissolution of the composition in water when the degree of neutralization is too high. The lower range for partial neutralization of 15% is controlled by the need for improved productivity. A suitable range of partial neutralization is with base added in an amount to neutralize 20 to 40% of the carboxylic acid groups of the binder if completely reacted.

Partial neutralization of the acid binder is an effective means of increasing productivity including development or stripping rates in aqueous developable films in which a wide range of inorganic and organic bases can be employed to achieve satisfactory results. However, because of effects on the physical properties of the film there may be particular advantages and disadvantages associated with the choice of base dependent on the binder and intended end use of the film. In some instances an organic amine may be preferred over an inorganic base due to greater compatibility with the coating solution and the coated film. A diamine may be preferred over a monamine if a more flexible film is desired. An inorganic base or an amino substituted acrylic ester or amino substituted methacrylic ester may be favored over an amine to avoid formation of a copper-amine complex when the film is to be laminated to a copper support. A varying degree of toughness and tackiness can be produced in the film as the amount of and type of base is varied within the scope of the present invention. In addition a particular advantage in terms of improved development latitude has been observed when an amino substituted acrylic ester is used for partial neutralization.

Partial neutralization can be performed with inorganic and organic bases. A preferred group of bases includes an alkali metal hydroxide, a $C_1$-$C_{12}$ aliphatic amine and an amino substituted acrylic ester or amino substituted methacrylic ester. Suitable bases are: potassium hydroxide, sodium hydroxide, ammonium acetate, triethylamine, triethanol amine, 2-amino-2-ethyl-1,3-propanediol, N,N-dimethylaniline, N,N,N' , N' -tetra-(hydroxyethyl)ethylene diamine, N,N,N' ,N' -tetramethylethylene diamine, N,N,N' ,N' -tetramethylbutane diamine, N,N,N' ,N' -tetramethyl hexane diamine, N,N-diethylamino ethyl acrylate, N,N-diethylaminoethyl methacrylate and N,N-dimethyl amino ethyl acrylate. A preferred embodiment of the invention involves the partial neutralization of a carboxylic acid binder with an ester such as N,N-diethylaminoethylacrylate, N,N-diethylaminoethyl methacrylate or N,N-dimethyl aminoethyl acrylate.

Acid binders useful for the practice of the present invention generally contain from 5 to 15% by weight of the binder acid groups to be suitable for aqueous development. These acid binders should have an acid number in the range from 40 to 140.

Preferably the acid binders will have an acid number in the range of 60 to 80. Acid binders are well known in photopolymerizable compositions and may be synthesized or one or more of the many commercially available polymers may be used. Examples of commercially available acid binders are polyacrylates such as Carboset® 525,526 and XL27 available from B. F. Goodrich with acid numbers in the range from 80 to 100.

Aqueous processibility in the present context means the photosensitive composition can be processed in an aqueous solution containing 1% sodium carbonate. The solution at a temperature of 40°C during a time period of five minutes will remove areas of the composition which have not been exposed to actinic radiation but will not remove exposed areas.

The binder should be of sufficient acidity to render the composition processible in aqueous developer. Useful aqueous-processible binders include those disclosed in U.K. Patent No. 1,507,704. Useful amphoteric polymers include interpolymers derived from N-alkylacrylamides or methacrylamides, acidic film-forming comonomer and an alkyl or hydroxyalkyl acrylate such as those disclosed in U.S. Patent No. 3,927,199.

Suitable binders which can be used as the sole binder if they meet the above aqueous processibility test or in combination with others include the following: Polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers; polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene,

copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula HO(CH₂)ₙ OH, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides, e.g., N-methoxymethyl polyhexamethylene adipamide; cellulose esters, e.g., cellulose acetate, cellulose acetate succinate and cellulose acetate butyrate; cellulose esters, e.g., methyl cellulose, ethyl cellulose and benzyl cellulose; polycarbonates; polyvinyl acetal, e.g., polyvinyl butyral, polyvinyl formal; polyformaldehydes.

Suitable monomers which can be used as the sole monomer or in combination with others include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar componds as disclosed in U. S. Patent No. 3,380,831, 2,2-di(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylenically unsaturated monomers mentioned above, the layer can also contain at least one of the following free radical-initiated, chain-propagating, addition-polymerizable, ethylenically unsaturated compounds having a molecular weight of at least 300. Preferred monomers of this type are an alkylene or a polyalkylene glycol diacrylate prepared from an alkylene glycol of 2 to 15 carbons or a polyalkylene ether glycol of 1 to 10 ether linkages, and those disclosed in U. S. Patent No. 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such materials wherein the ethylenically unsaturated groups, especially the vinylidene groups, are conjugated with ester or amide structures.

Preferred free radical-generating addition polmerization initiators activatable by actinic light and thermally inactive at and below 185°C include the sustituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione. Other photoinitiators which are also useful, even though some may be thermally active at temperatures as low as 85°C, are described in U. S. Patent No.

2,760,863 and include vicinal ketaldonyl alcohols, such as benzoin, pivaloin, acyloin ethers, e.g., benzoin methyl and ethyl ethers; alpha-hydrocarbon-sustituted aromatic acyloins, including alpha-methylbenzoin, alpha-allylbenzoin and alpha-phenylbenzoin. Photoreducible dyes and reducing agents disclosed in U. S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenyl-imidazolyl dimers with hydrogen donors, and mixtures thereof as described in U. S. Patents: 3,427,161; 3,479,185; and 3,549,367 can be used as initiators. Also useful with photoinitiators and photoinhibitors are sensitizers disclosed in U. S. Patent No. 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibition are the nitroso compositions disclosed in U. S. Patent No. 4,168,982.

Various dyes and pigments may be added to increase the visibility of the resist image. Any colorant used, however, should preferably be transparent to the actinic radiation used.

In the practice of the present invention, a variety of supports may be used for the resist element. A suitable support having a high degree of dimensional stability to temperature changes may be chosen from a wide variety of films composed of high polymers, e.g., polyamides, polyolefins, polyesters, vinyl polymers, and cellulose esters. A preferred support for the present invention is polyethylene terephthalate.

Also a cover sheet can be employed in conventional manner with the photopolymerizable material between the support and cover sheet. The cover sheet can have the same composition as the support provided the cover sheet releases more readily than the support from the photopolymerizable composition. The supported photopolymerizable composition is stored in roll form prior to use.

Once the photosensitive composition has been coated on a support it can be then laminated to a surface to serve as a photoresist. Copper is a preferred surface for the practice of the present invention.

In use of the photopolymerizable element, it is unwound from a roll, the cover sheet is removed of and the supported photopolymerizable composition is laminated to a support substrate. Therefore with or without the support in place, the photopolymerizable layer is imagewise disposed - (i.e., through a photomask) to actinic radiation, now-exposed areas of the photopolymerizable layer removed and the substrate is permanently modified by etching or plating where it is not covered by the layer which was once photopolymerizable.

The invention will be more clearly understood by reference to the following examples. All parts and percentages are by weight unless otherwise indicated.

Example 1

Six aqueous developable photopolymer solutions were prepared with the following weight percent compositions:

| | A | B | C | D | E | F |
|---|---|---|---|---|---|---|
| Methylmethacrylate/ethylacrylate/acrylic acid copolymer (55/38/7) molecular weight 42,000, Acid No. 80, Tg 52° C | 44.1 | 43.2 | 42.8 | 43.6 | 43.4 | 43.4 |
| Methylmethacrylate/ethylacrylate/acrylic acid copolymer (71/17/12) molecular weight 200,000, Acid No. 100, Tg 74° C | 23.8 | 23.3 | 23.1 | 23.5 | 23.5 | 23.4 |
| Triethylamine | – | 2.1 | – | – | – | – |
| Triethanolamine | – | – | 3.0 | – | – | – |
| N,N,N',N'-tetramethyl ethylene diamine | – | – | – | 1.2 | – | – |
| N,N,N',N'-tetramethyl-butane diamine | – | – | – | – | 1.5 | – |
| N,N,N',N'-tetramethyl-hexane diamine | – | – | – | – | – | 1.6 |
| 5-Clorobenzotriazole | 0.3 | 0.3 | 0.3 | 0.3 | 0.3 | 0.3 |
| o-Cl-HABI | 2.2 | 2.2 | 2.1 | 2.2 | 2.2 | 2.2 |
| Leuco crystal violet | 0.2 | 0.2 | 0.2 | 0.2 | 0.2 | 0.2 |
| Tricresylphosphate | 0.8 | 0.8 | 0.8 | 0.8 | 0.8 | 0.8 |
| Michler's ketone | 0.2 | 0.2 | 0.2 | 0.2 | 0.2 | 0.2 |
| Diethylhydroxylamine | 0.2 | 0.2 | 0.2 | 0.2 | 0.2 | 0.2 |
| trimethylolpropane triacrylate | 26.3 | 25.8 | 25.5 | 26.0 | 26.0 | 25.9 |
| 80% copper pthalocyanine pigment dispersion in 20% trimethylol-propane | 1.5 | 1.5 | 1.5 | 1.5 | 1.5 | 1.5 |
| 2-Mercaptobenzoxazole | 0.3 | 0.3 | 0.3 | 0.3 | 0.3 | 0.3 |

A 34% solids composition in 93% $CH_2Cl_2$-7% $CH_3OH$ solvent was coated at 1.5 mils on a polyethylene terephthalate support. The percentages of amines in B-F represent 0.2 equivalents of base per equivalent of acid in the binder and produced films having greater flexibility than the control.

Samples of the Control A and the partially neutralized experiments B-F were laminated to copper boards and exposed on a PC24 Riston® exposure device through a plating target. After exposure, triplicate samples were developed in $Na_2CO_3$ at 41°C. An average time for development was determined for the three samples by observing the time for the board to clear. After measuring the resolution of the polymerized photoresist, it was removed by stripping in 1.5% KOH at 68°C. The stripping time was observed. Results are summarized in Table 1.

## Table 1

| Film | Exposure | Time to Clear | Time to Strip |
|------|----------|---------------|---------------|
| A | 10 cts | 48 sec. | 72 sec. |
| B | 10 cts | 41 sec. | 49 sec. |
| C | 10 cts | 41 sec. | 42 sec. |
| D | 10 cts | 40 sec. | 53 sec. |
| E | 10 cts | 38 sec. | – |
| F | 10 cts | 39 sec. | 53 sec. |

Whereas B-F showed improved development and stripping times in comparison to the Control A, resolution of lines and spaces was observed on all samples before etching. After the step of etching control A was slightly better in resolution than experiments B-F.

. Example 2

Partially neutralized films were prepared as in Example 1 except substituting from 0.1 to 0.5 equivalents of base of the following: potassium hydroxide, sodium hydroxide, ammonium acetate, N,N,N' ,N' -tetra(hydroxyethyl)ethylene diamine, 2-amino-2-ethyl-1,3-propanediol, N,N-dimethylaniline N,N-diethylamino ethyl acrylate, N,N-diethylamino ethylmethacrylate and N,N-dimethylamino ethyl acrylate.

In comparison to control films the partial neutralization of the acid binder produced films which had improved flexibility before being exposed. These films incorporating the partial neutralization feature of the present invention could be stretched further than a control film without breaking.

Samples of these films also demonstrated improved development and stripping rates comparable to those shown in Table 1.

This illustrates that a wide range of inorganic and organic bases, amines and acrylates are suitable for the practice of the present invention when used to neutralize from 0.1 to 0.5 equivalents of the acid groups from the acid binder.

Example 3

A film was prepared as in Example 1 except that the amount of triethylamine was increased to 0.6 equivalents. Attempts to develop exposed film samples proved unsuccessful since with this amount of neutralization a resist pattern could not be otained since the composition was stripped off by the carbonate developer. It was observed that the resist pattern became visible but then broke into large pieces until the board was stripped free of the composition neutralized with 0.6 equivalents of base.

Example 4

A solution was prepared with the following:

| CH$_2$Cl$_2$ | 300 g |
|---|---|
| 5-Cl-benzotriazole | 2.4 g |
| Diethylhydroxylamine | 1.2 g |
| Michler's ketone | 1.2 g |
| o-Cl-HABI | 13.2 g |
| Tricresyl phosphate | 22.8 g |
| TMPEOTA[1] | 150.36 g |
| Victoria Green Dye | 0.21 g |
| Leuco crystal violet | 1.2 g |

[1]Ethoxylated triacrylate monomer stabilized with 170±10 ppm methylhydroquinone.

This solution was split into 5 portions of 82.1 g each to which the following gram additions were made:

| | 1 | 2 | 3 | 4 | 5 |
|---|---|---|---|---|---|
| CH$_2$Cl$_2$ | 102.4 | 100.96 | 99.51 | 96.63 | 90.85 |
| CH$_3$OH | 12.4 | 12.4 | 12.4 | 12.4 | 12.4 |
| Methylmethacrylate/ethylacrylate/ acrylic acid copolymer (55/38/7) (as in Example 1) | 67.88 | 67.88 | 67.88 | 67.88 | 67.88 |
| Ethyl cellosolve | 5.15 | 5.15 | 5.15 | 5.15 | 5.15 |
| Triethanolamine | – | 1.44 | 2.89 | 5.77 | 11.55 |
| Equivalents/mole acid | 0 | 0.1 | 0.2 | 0.4 | 0.8 |

The solutions were coated on polyethylene terephthalate with an 8 mil doctor knife. Solution 5 exhibited a small viscosity increase as well as a decrease in green color.

Film samples were laminated to copper boards and held for 2 hours. After a 30 ct exposure in the PC-24 printer these thicker films were machine processed in a Riston® Aqueous Developer System ADS-24 with 1% Na$_2$CO$_3$ at 40°C at a conveyor setting of 150 using a top spray pressure setting of 30 psi and bottom 9 psi. Table 2 contains pertinent results.

## Table 2

| Unexposed Color | Cover-sheet Adhesion | Resist Adhesion | Time to Test 1 | Time to Clear Test 2 | Development Speed* |
|---|---|---|---|---|---|
| Film 1: Drab green | Ex. | Ex. | 24.4 | 23.3 | 4.4 FPM |
| Film 2: Drab green | Ex. | Ex. | 22.5 | 22.8 | 4.6 FPM |
| Film 3: Green | Good | Ex. | 20.9 | 21.4 | 5.0 FPM |
| Film 4: Light green | Good | Ex. | 17.2 | 17.5 | 6.0 FPM |
| Film 5: Red-brown | Good | Ex. | 11.5 | 12.0 | 8.9 FPM |

**FPM is feet per minute**
**Ex. is Excellent**
**All times are in seconds**

The decrease in green color appears to be proportional to the amount of amine added. However this interaction did not prevent the development of a resist pattern on the copper boards even at the highest level of amine addition. i.e., 0.8 equivalents of base per acid from the binder. However the image on film 5 was not sharp enough for practical use in comparison with the control and films 2-4. Attempts to obtain a satisfactory resist image on film 5 by increasing the conveyer speed to 10 FPM also failed.

Example 5

Films were prepared as in Example 4 except that KOH was used instead of triethanolamine. Satisfactory results were obtained when from 0.1 to 0.5 equivalents of base were added per mole of acid binder.

Example 6

A stock solution was prepared as follows:

| Methylene chloride | 1120.7 | g |
|---|---|---|
| Methanol | 97.5 | g |
| Benzophenone | 30.0 | g |
| Michler's ketone | 0.9 | g |
| o-Cl-HABI | 3.6 | g |
| Victoria Green Dye | 0.36 | g |
| Leuco crystal violet | 1.80 | g |
| Diethylhydroxyl amine | 1.20 | g |
| Total | 1256.1 | g |

Two 209.3 g portions of this stock solution were split off to receive the control and experimental additions.

| | Control | Experiment |
|---|---|---|
| Methylmethacrylate/-ethylacrylate/-methacrylic acid (51/29/20) mol. wt.45,000, Acid No. 140, Tg 80-90°C | 65.7 g | 55.7 g |
| Methylmethacrylate/-ethylacrylate/acrylic acid copolymer (37/56/7) mol. wt. 260,000, Acid No. 76-85 | – | 10 g |
| TMPEOTA | 28 | 27 |
| N,N-diethylaminoethyl acrylate | – | 1[8] |

The solutions were coated and exposed and processed as in Example 4. The experiment demonstrated satisfactory adhesion along with improved flexibility and development and stripping rate in comparison to the control. This illustrates that partial neutralization can be applied to high acid binders, i.e., Acid No. 140.

Example 7

Four films were prepared as in Example 1 except that the experiments involved the substitution of 0.2 equivalents of three aminoacrylates for trimethylolpropane triacrylate monomer. Table 3 contain results on processed films.

## Table 3

| Film Addition | Time to Clear | Time to Strip |
|---|---|---|
| None control | 35 | 64 |
| N-N-diethylaminoethyl acrylate | 29 | 31 |
| N,N-diethylaminoethylmethacrylate | 24 | 28 |
| N,N-dimethylaminoethylacrylate | 25 | 30 |

**Time is in seconds**

The illustrates that a monomer addition can serve to provide partial neutralization of the acid binder according to the practice of the present invention. It was also observed that amino acrylate monomers can be used to maintain good development latitude in partially neutralized films, relative to other amines tested, i.e., mono function, difunction or alkali base.

## Claims

1. In an element suitable to be wound in a roll comprising a flexible support film and an aqueous processible photopolymerizable resist composition comprising a photpolymerizable ethylenically unsaturated monomer, a photoinitiator or photoinitiator system and a binder wherein the improvement comprises said composition containing a partially neutralized acid binder formed from binder containing carboxylic acid groups with an acid number in a range from 40 to 140 and base sufficient to neutralize from 15 to 55% of the carboxylic acid groups if completely reacted.

2. The element of claim 1 wherein the acid number is in a range from 60 to 100.

3. The element of claim 1 wherein the base is sufficient to neutralize 20 to 40% of the carboxylic acid groups if completely reacted.

4. The element of claim 1 wherein the base is an alkali metal hydroxide, $C_1-C_{12}$ aliphatic amine or amine substituted acrylic monomer.

5. The element of claim 1 wherein oil base has been reacted.

6. The element of claim 1 wherein base is present.

7. The element of claim 1 wherein an alkali metal hydroxide is employed.

8. The element of claim 1 wherein a $C_1-C_{12}$ aliphatic amine is employed.

9. The element of claim 1 wherein an amino substituted acrylic ester or amino substituted methacrylic ester.

10. The element of claim 9 wherein the ester is N-N-diethylaminoethylacrylate, N,N-diethylaminoethyl methacrylate of N,N-dimethyl aminoethyl acrylate.

11. In a method of making a printed circuit board comprising the steps of:

(i) laminating a supported photosensitive layer to a surface.

(ii) exposing imagewise the photosensitive layer to actinic radiation.

(iii) removing areas of the photosensitive layer not exposed to actinic radiation, and

(iv) modifying permanently by etching or plating a bared area of the surface;

wherein the improvement comprises laminating supported layer comprising at least one layer of a photosensitive composition comprising a photopolymerizable ethylenically unsaturated monomer, a photoinitiator or photoinitiator system and a partially neutralized acid binder formed from a binder containing carboxylic acid groups with an acid number in a range of 40 to 140 and a base sufficient to neutralize from 15 to 55% of the carboxylic acid groups if completely reacted.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | FR-A-2 384 812  (E.I. DU PONT)<br>* Page  3, line 5 - page 9, line 39; example 1; claim 13 * | 1-11 | G 03 C    1/68 |
| X,Y | FR-A-2 350 625  (JAPAN SYNTHETIC RUBBER CO.)<br>* Examples  32,33 * & US - A - 4 275 142 (Cat. D) | 1-11 | |
| Y,D | US-A-2 893 868  (A.L. BARNEY)<br>* Column  1, line 15 - column 2, line 71; examples 5-12 * | 4,9,10 | |

TECHNICAL FIELDS
SEARCHED (Int. Cl.4)

G 03 C

The present search report has been drawn up for all claims

| Place of search | Date of completion of the search | Examiner |
|---|---|---|
| THE HAGUE | 03-07-1986 | MARKOWSKI |